# EUROPEAN PATENT APPLICATION

(11) **EP 3 076 550 A1**
(43) Date of publication of application: **05.10.2016**
(21) Application number: 15161637.2
(22) Date of filing: 30.03.2015
(51) Int. Cl.: H03K 17/691, H03K 17/06, H03K 17/567

(54) **Circuit and a method for the galvanically isolated control of a semiconductor switch**

(71) Applicant: ALSTOM Technology Ltd, 5400 Baden (CH)
(72) Inventor: Nicholls, Jonathan Christopher, Derby, DE1 3AJ (GB)
(74) Representative: Day, Caroline Margaret

(57) **Abstract**

Methods and apparatus for providing power for a gate signal for a semiconductor switching element are described. In some examples, an alternating current is provided on a primary conductor and induces a current in a secondary conductor. Power is derived therefrom to provide a gate signal. A frequency modulation is applied to the alternating current on the primary conductor and detected in the induced current in the secondary conductor. In some examples, the frequency modulation may be indicative of a data signal, for example a gate control signal.

## Description

### FIELD OF THE INVENTION

The invention relates to gate signalling, and in particular but not exclusively to providing gate signals for controlling a switching state of at least one semiconductor switching element.

### BACKGROUND OF THE INVENTION

Particular problems exist with operating switches in relatively high voltage environments. For example, in a mechanical switch, arcing can occur on opening, in which ionisation of the air between separating contacts allows the air to act as a conductor. This is potentially dangerous in itself and also causes wear to the equipment, which therefore requires regular review and renewal.

Solid state switches (i.e. semiconductor switches such as Insulated Gate Bipolar Transistors (IGBTs), Metal-Oxide Semiconductor Field-Effect Transistors (MOSFETS), and the like) do not suffer from arcing, but currently available solid state switches are not generally able to support the full voltage of a relatively high voltage environment and/or switches which can support higher voltages are expensive. This means that, where they are used in a high voltage environment, it is usual to provide several (in some examples up to a hundred or more) solid state switching elements connected in series to provide a switch. In such a series connection, it is often desirable to control switching elements to operate substantially simultaneously to ensure that the voltage supported is shared over the series connection, and not supported fully by the element, or subset of elements, which switch first.

In order to switch a semiconductor switching element, a gate driving signal is usually provided by a gate controller circuit. In a relatively high voltage environment, for protection, such gate controllers may be galvanically isolated from other circuitry and from ground potential. A gate controller may be provided with power via a transformer, which allows the isolation to be maintained. Switching signals, which control when a gate of a semiconductor switching element is driven, may be supplied optically, for example via an optical fibre, again ensuring that isolation is maintained. In some examples, such as is set out in 'Gate driving of high power IGBT through a Double Galvanic Insulated Transformer' by Stéphane Brehaut et al, both a switching signal and a power transfer signal are induced in a wire loop by a first transformer, which in turn induces a signal in a transformer winding capable of supplying power to gate drive circuitry. The switching signal and power transfer signal are at distinct, well separated frequencies (for example, 8Mhz and 20kHz respectively) and are separated by the gate drive circuitry using a high pass filter.

However, transmitting such high frequency switching signals using a power transfer signal as a carrier wave requires the use of high frequency modulators and high order filters, which may be difficult to implement and/or cause electromagnetic emissions which may interfere with nearby equipment or cause compliance issues. Using a relatively low frequency power transfer signal with high frequency signalling commands also complicates optimisation of the transformer components, as the transformer should be designed to have good performance characteristics at both low and high frequencies.

### SUMMARY OF THE INVENTION

According to a first aspect of the invention, there is provided a method of providing power for a gate signal to a semiconductor switching element comprising:
providing an alternating current on a primary conductor;
inducing a current in a secondary conductor using the alternating current on the primary conductor;
deriving power to provide the gate signal from the current induced on the
secondary conductor;
   wherein the method further comprises:
applying a frequency modulation to the alternating current on the primary conductor; and
detecting the frequency modulation in the induced current in the secondary conductor.

In such a method, the alternating current on the primary conductor not only provides power but also allows for a detectable frequency modulation, which can be used for communication with a gate controller, and which may remove the need for separate power and communication systems for a gate controller comprising gate driving circuitry.

For example, the frequency modulation applied to the alternating current on the primary conductor may be indicative of a data signal and the method may comprise deriving a data signal from the detected frequency modulation.

In a particular example, the data signal may be a control signal. In such examples, the method may further comprise controlling the gate signal according to the detected frequency modulation. This is a convenient manner of providing a gate control signal, for example controlling the timing of the gate signal, or being indicative of one or more switching modes. In some examples, the data signal may comprise instructions for setting or altering a gate voltage, which may in some examples improve on-state performance. As will be familiar to the skilled person, increasing gate voltage from, a 'standard' gate voltage (for example, this may be around 15V for some IGBTs) may reduce the on-state voltage drop and thus improve conduction losses. Reducing gate voltage, but not fully turning a switching element off, may be desirable in certain fault conditions, as it causes the switching element to self-limit current levels.

In other examples, the data signal may comprise a request for a response from circuitry associated with the semiconductor switching element(s). The response requested may comprise one or more indications of status, such as a switching element switch state (for example, ON or OFF), switching element health status, switching element temperature, or the like.

In some examples, the method may further comprise detecting a predetermined identifier in the detected frequency modulation. As will be familiar to the skilled person, in some examples of gate driving methods, multiple gate controllers derive power from a common primary conductor loop. Including an identifier allows one or a subset of the gate controllers to be specifically addressed, such that any further data may be processed and/or acted on by just the addressed gate controller(s). As such, the method may comprise a method of addressing a gate controller comprising encoding a predetermined gate controller identifier as a frequency modulation.

The frequency modulation may be Frequency Shift Keying (FSK). As will be appreciated by the skilled person, FSK is an example of frequency modulation in which digital information is transmitted through discrete frequency changes of a carrier wave. The FSK may be binary, such that distinct frequencies represent respectively a 0 or a 1. Such a frequency modulation may be readily detected in the induced current.

In some examples, the step of detecting the frequency modulation may comprise monitoring the induced current for at least two cycles. This may be advantageous in increasing the certainty that a frequency shift has occurred. In some examples, detecting the frequency modulation may comprise at least one of monitoring the zero crossings of a current waveform; monitoring the time between voltage peaks and/or high pass filtering the induced current in the secondary conductor. In some examples, the current waveform may be sampled, and the samples compared to previously determined values. To give a particular example, at 20Khz, each positive peak of voltage appears every 50 microseconds but at 25Khz, each peak will occur every 40 microseconds. As will be appreciated by the skilled person, such detection may be carried out by readily implemented timing circuits or frequency detectors. If high pass filtering is carried out, a high-pass filter that is sensitive to the frequencies used in the modulation could be implemented.

According to a second aspect of the invention, there is provided control circuitry arranged to control the switching state of a semiconductor switching element, the control circuitry comprising:
a current source, arranged to supply an alternating current;
a modulator, arranged to modulate the frequency of the alternating current;
a primary conductor, arranged to carry the alternating current; and
at least one gate controller comprising:
   a power unit arranged to derive power from the primary conductor via electromagnetic induction;
   a demodulator arranged to identify a frequency modulation in the alternating current and to determine a data signal therefrom; and
   gate drive circuitry arranged to drive a gate of a semiconductor switching element using power derived by the power unit.

Such control circuitry is advantageous in that both a data signal and power can be derived from the current carried on the primary conductor and used by the gate controller. The data signal may be represented by the modulation applied to the current by the modulator.

The data signal may, in some examples, be used to derive a control signal, for example a semiconductor switching element control signal; an information request signal; and/or a gate drive control signal.

The gate drive circuitry may be arranged to drive a gate of a semiconductor switching element according to a semiconductor switching element control signal (which may control the timing of a gate signal) or a gate drive control signal (which may control parameters such as the magnitude of the gate drive signal). Such an arrangement may remove the need for a separate switching signal to be provided to the gate controller.

In some examples, the primary conductor is a current loop and/or each power unit comprises a ring core transformer winding. In some examples, the core may comprise a ferrite ring, for example a powered ferrite ring. Such an arrangement will be familiar to the skilled person for providing primary and secondary windings of a transformer, which therefore allows the gate controller to be galvanically isolated from the current source. In some examples, the design of the core may be optimised based on the range of frequencies anticipated as the induced signal.

The modulator may be arranged to control the frequency of the alternating current using frequency shift keying, in some examples comprising binary shift keying. Such a frequency shift may be readily detectable.

The modulator may be arranged to control the frequency of the alternating current within a range determined by at least one of: a frequency range of the power unit, a desired switching speed of the semi conductor element, demodulator performance limits, anticipated frequency drift of the current source, noise in the control circuitry, or the like. The control circuitry may for example have a range of frequencies in which power is transferred efficiently, and outside that range, losses may become unacceptably high. While a large frequency change may be more readily detectable, it may result in losses and such factors may be balanced by the skilled person.

In some examples, the control circuitry may comprise a plurality of gate controllers. Such an arrangement will be familiar to the skilled person and may be advantageous, in particular where a number of semiconductor switching elements are required in close proximity to one another. The methods and apparatus described herein may be particularly convenient in arrangements in which the switching elements are to be operated substantially simultaneously, as the plurality of gate controllers may receive the same frequency modulated signal substantially simultaneously. However, in particular examples, the modulator may alternatively or additionally be arranged to modulate the alternating current to apply a signal indicative of an identifier of one or more of the gate controllers, and the demodulator of each gate controller is arranged to determine, from the data signal, if the data signal comprises an identifier corresponding to that gate controller. This allows for signals to be addressed to a particular one, or subset, of switching elements, thus allowing the switching elements to be controlled individually or as subsets.

According to a third aspect of the invention, there is provided a gate controller comprising a power unit arranged to derive power via electromagnetic induction from an alternating current; a demodulator arranged to identify a frequency shift in the alternating current and to determine a data signal therefrom; and gate drive circuitry arranged to drive a gate of a semiconductor switching element using power derived by the power unit.

Such a gate controller is capable of receiving a data signal from the same signal from which it derives power, and thus may not require a separate data input. In some examples, the data signal may be used to derive a control signal, and the gate drive circuitry may be arranged to drive a gate of a semiconductor switching element according to the control signal.

The power unit may comprise a ring core and/or a power conditioning module arranged to rectify the induced current. Such a power conditioning module may further be arranged to smooth and/or regulate the current, for example to provide a direct current suitable for use as a gate driving signal.

Features described in relation to one aspect of the invention may be combined with those of another aspect of the invention. In particular, the gate controller and/or control circuitry may be arranged to carry out at least some steps of the method of the first aspect of the invention. The gate controller of the third aspect of the invention may be arranged to provide the gate controller of the control circuitry of the second aspect of the invention.

The method, gate controller and/or control circuitry may be arranged for operation in a relatively high voltage environment, for example in the control of switches in a converter such as an Alternate Arm Converter (AAC) (in a particular example, a director switch thereof) or in a phase of a Series Bridge Converter (SBC), or a modular multilevel converter (MMC).

The invention further comprises methods of use of the gate controller and/or control circuitry described above.

Embodiments of the invention are now described, by way of example only, with reference to the following Figures.

### BRIEF DESCRIPTION OF THE DRAWINGS

**Figure 1** shows a prior art example of a circuit for powering a plurality of gate controllers;
**Figure 2** shows an example of a control circuit for controlling a switching element according to any embodiment of the invention;
**Figure 3** shows signals and current forms within the control circuit of Figure 2;
**Figure 4** shows an example of an Alternate Arm Converter (AAC); and
**Figure 5** shows a director switch in the AAC of Figure 4.

### DETAILED DESCRIPTION OF EMBODIMENTS

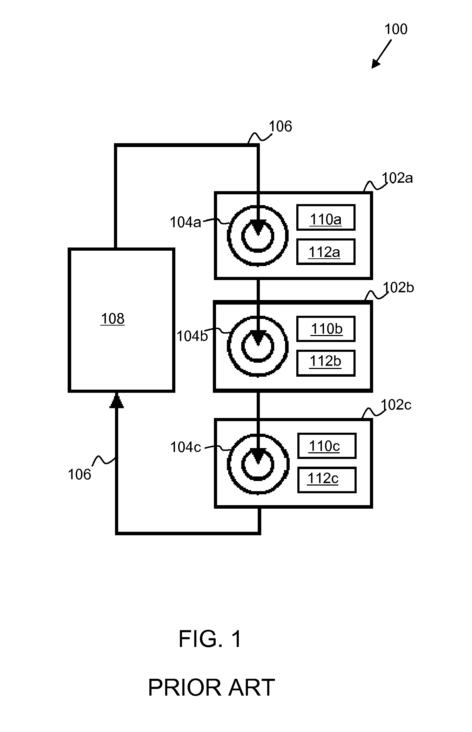

Figure 1 shows a prior art example of a circuit 100 capable of providing power for gate signals to control a plurality of semiconductor switching devices.

The circuit 100 comprises a plurality of gate controllers capable of controlling a gate of a semiconductor switching element such as an Insulated Gate Bipolar Transistor (IGBT), a MOSFET, or similar gate controlled device. In the illustrated example, the gate controllers are provided as gate boards 102a, b, c, each capable of acting as gate controller for a switching element. Each gate board 102 comprises a secondary conductor, which provides a secondary winding 104a, b, c of a transformer and, in this example, comprises a ring core. A common primary conductor 106, in this example a loop of wire, passes through the plurality of gate boards 102, and specifically through a central region of the secondary windings 104 on each board 102. The primary conductor 106 and secondary windings 104 are galvanically isolated from one another, and the secondary windings 104 (and indeed the gate boards 102) are galvanically isolated from ground.

A current source 108 is arranged to provide an AC current in the primary conductor 106 (for example, a 20kHz sine or triangular wave at around 2 amps). Current is thereby induced in the secondary windings 104. Each gate board 102 further comprises a power conditioning module 110a, b, c, and gate drive circuitry 112a, b, c. The power conditioning modules 110 are arranged to rectify, smooth and regulate the induced current to provide a DC power source for the gate drive circuitry 112, which comprises logic capable of causing and controlling a gate drive signal to control or change the switching state of a semiconductor switching element such as an Insulated Gate Bipolar Transistor (IGBT), a MOSFET, or similar gate controlled device according to an input control signal. The secondary winding 104 and the power conditioning module 110 of each board 102 therefore comprise a power unit capable of deriving power from the current on the primary conductor 106 via electromagnetic induction, and the power is used to drive the gate of a semiconductor switching device.

One benefit of such an arrangement is that a plurality of gate boards 102 can be powered from one common primary conductor 106, and without requiring a direct galvanic connection to the current source 108. The voltage isolation may be dependent on the insulation rating of the primary conductor 106, the air gap between the primary conductor 106 and the secondary windings 104, and on the insulation ratings of the secondary windings 104 on the gate board 102, which may be determined according to the voltage difference.

The primary conductor 106 may carry a relatively high frequency AC current, for example in the range 15 kHz to 20 kHz, as this results in lower hysteresis losses in a core of the secondary winding 104 and/or allows for a smaller core, while also operating at a switching frequency above audible range (which prevents the transformer from emitting an audible tone). The current magnitude of the primary conductor 106 may be determined according to the requirements for power on the secondary windings 104 bearing in mind any magnetic losses.

As well as providing power, each gate board 102 may be associated with a signal source to provide the input control signal to cause the gate board to control the switching state of a switching element. To maintain isolation, and as will be familiar to the skilled person, such a control signal may be provided by a fibre optical system. Fibre systems are generally reliable, but prone to degrading. The fibre ends may require polishing and precise termination, and acceptable fibre bending radius may be restrictive, providing additional complications to equipment layout.

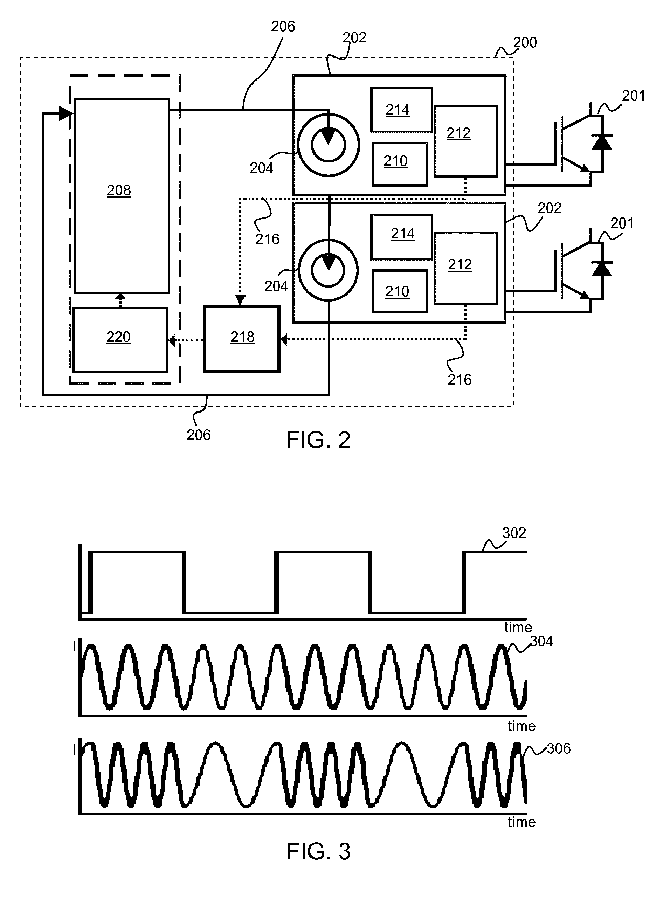

Figure 2 shows an example of control circuitry 200 according to an embodiment of the present invention, which operates to control the switching state of at least one switching element 201, in this example, an IGBT.

The control circuitry 200 comprises at least one gate board 202 (two are shown in Figure 2, but it will be appreciated that there may be one, or more than two gate boards 202). Each gate board 202 again comprises a secondary winding 204 of a transformer, in this example each comprising a ring core, which may for example be a powered ferrite ring, although other materials could be used. A primary conductor 206 (which in this example comprises a common primary conductor for both gate boards 202), in this example a loop of wire, passes through the secondary winding 204 as described in relation to Figure 1.

A current source 208 is arranged to provide an AC current in the primary conductor 206 and a current is thereby induced in the secondary windings 204.

Each gate board 202 further comprises a power conditioning module 210 and gate drive circuitry 212. In this example, each gate board 202 further comprises a demodulator 214. The gate drive circuitry 212 further comprises an output (which in this example is a fibre optic data cable 216), which is arranged to supply data to a controller 218. This cable 216 may be arranged to transmit data such as operational status data. This data may include, for example, any of an IGBT on/off state confirmation, a 'handshake' process with a controller 218, for example declaring a status as 'OK' or indicating a fault state/unavailability, data indicative of a detection of overcurrent or overvoltage, a fault in the gate board logic, etc. In other examples, there may be no 'data-back' facility, or it may be provided by means other than a fibre optic cable.

In examples comprising multiple gate boards 202, all of the gate boards 202 may be arranged to supply data to a common controller 218, or to separate controllers.

The controller 218 in this example is further arranged to control a modulator 220, which in turn controls the current source 208. In this example, the current source 208 is an H-bridge current source generator, which may be controlled to produce a current carrying a data signal encoded as a frequency modulation. In other examples, the current source 208 may have another topologies, such as a half-bridge topology.

In this example, a data signal is sent to the gate board 202 by encoding the current provided on the primary conductor 206. This is achieved through modulation of the AC current applied by the modulator 220. In particular, Frequency Modulation (FM) techniques, such as Frequency Shift Keying (FSK) may be used to encode one or more digital data signals which can then be detected by frequency detector circuitry provided within the demodulator 214 of the gate board 202.

In one example, with reference to Figure 3, a plurality of gate boards 202 are required to switch their associated switching element 201 on and off with a 50% duty cycle according to an on/off gating signal 302. The current source 208 may be controlled to generate a current I (line 304), with a frequency of for example 20kHz. This can be thought of as a carrier wave, and is further controlled by the modulator 220 such that the frequency temporarily shifted, in this example from 20 kHz to 25 kHz, according to control signals generated by and sent from the controller 218 (line 306). The modulator 220 in this example is an FSK modulator arranged to alter the frequency of the H-bridge inverter providing the current source 208 and driving the primary conductor 206.

In this example, 20kHz may be indicative of a logic '1' and 25kHz is indicative of logic '0'. Thus line 306 is representative of data comprising 1s and 0s, representing the gating signal 302 (e.g. 1s represent a desired 'ON' state of the switching element 201 and 0s represent a desired 'OFF' state, although the reverse could be true). It will be noted that the flow of current is not halted to represent a 0, instead this is represented by a change in frequency, and therefore the supply of power is not interrupted.

In this example, the demodulator 214 detects the shift in frequency using filters which may be for example passive filtering components or Field Programmable Gate Arrays (FPGA) to create band-pass filtering, or the like. In this example, to ensure that the shift in frequency from 20kHz to 25KHz is reliable detected, at least two full wave periods are sampled frequency shifted by the demodulator 214. In other examples, determining the frequency shift can be achieved for example by any of timing the zero crossings of the waveform, measuring the voltage peak timing and/or by high level band-pass filtering, and may comprise oversampling.

The design of the secondary winding 204 (for example, the choice of a core material about which the secondary winding(s) 204 are formed, or the size, shape, and/or construction of the core or windings 204) may be optimised for the particular change in frequency (or frequency range) applied to limit hysteresis losses (which could otherwise lead to poor power delivery to the gate board 202 and/or self-heating in a core about which the secondary winding 204 are formed).

In some examples, the range of frequencies used may be selected with knowledge of the performance of the components. For example, if a particular ferrite core which performs well at 20KHz is selected for use, then the range of frequencies considered to represent data may be limited to frequencies at which the performance is not unduly compromised. In the example above, the difference of 5kHz may be selected on the basis that it does not unduly affect efficiency of the ferrite core.

Another consideration for selecting the frequency range/difference is switching speed. In the example above, the change in frequency is 5Khz. The switching speed could be increased by applying an FSK shift of less than 5Khz, although this would in turn require greater accuracy from the demodulator 214. In addition, a greater shift of, for example, up to or more than 10 KHz would allows for easy discrimination of "on" and "off" signals, although the maximum switching speed would be lower. A frequency difference of around 20-25% may allow a change in frequency to be readily detected outside noise or the frequency drift of the current source 208 (an H-bridge current source 208, for example, will exhibit a frequency drift with temperature) without requiring a highly specified demodulator 214, although of course these factors could be balanced by the skilled person for a particular implementation, and the difference in frequency determined accordingly.

In one example, the primary conductor 206 carries a current of few amps in magnitude, and may be arranged to supply one or a plurality of gate boards 202 with an average of around 5 watts of power.

In some embodiments comprising a plurality, or stack, of gate boards 202, a data signal may be sent to individual boards 202 rather than the collective of the entire stack.

In such examples, some switching elements may be controlled to change state, while other may remain unswitched. For example, each gate board 202 may have an associated identifier, which may be an identifier as is used in CANBUS, RS232 or 12C serial communication. Any other serial communication protocol could be used. An identifier could be encoded into the alternating current carried by the primary conductor 206 as a frequency modulation and detected by the boards 202. Once an identifier has been recognised, a command also encoded as a data signal on the AC carried by the primary conductor 206 (for example, immediately following the identifier) could be demodulated and applied by the gate drive circuitry 212 on the addressed gate board(s) 202 only.

In some examples, a data signal may be a switching signal, or a status request, for example requesting any, or any combination of, operational status indications. Such indication may relate to a switching state (i.e. whether the IGBT 201 is on or off, a general 'status ok' or an indication of the presence of a fault state. Fault states may include overcurrent detection, overvoltage detection, an indication of a fault in gate board logic, a temperature warning indicating that the IGBT 201 may be over heating, or the like.

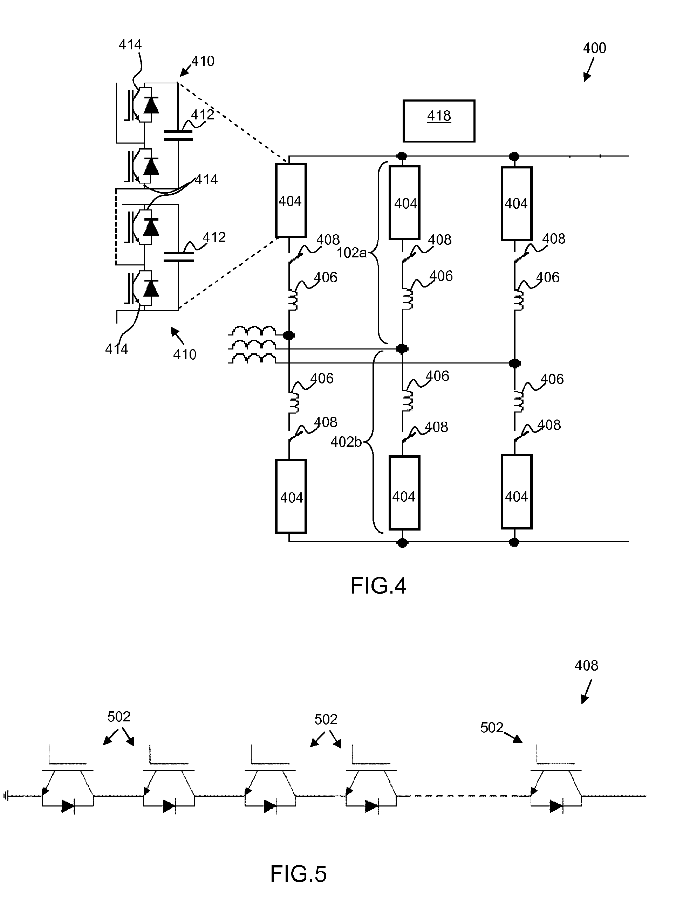

In one example, the control circuitry 200 may be arranged for use in a converter such as an Alternate Arm Converter 400 (AAC) as shown in Figure 4. In an AAC, each phase of the converter 400 has a pair of arms 402a, 402b (only labelled in relation to one of the pairs to avoid overcomplicating the figure). Each arm 402a, 402b comprises a stack of cells 404 arranged to synthesise a desired voltage, an arm inductor 406, and a director switch 408.

Two exemplary cells 410 that make up the stack of cells 404 in this example are shown in expanded view in Figure 4. As can be seen, each of the cells 410 comprises an energy storage means, which in this example is a capacitor 412, which can be inserted into the circuit, blocked or bypassed in order to approximate an ac voltage according to the switching state of a number of switching elements 414. The stack 404 may be made up of many such cells 410. In this examples, the cells 410 have a half bridge design, but they could have other designs, such as a full bridge design.

The director switch 408 controls which arm 402 is used to conduct the AC current, with one arm 402 of each pair being used in each half cycle to approximate an AC voltage.

In this example, the converter 400 further comprises a controller 418 arranged to control the function of the converter 400, and in particular the switching states of any of the switches therein. Such a controller 418 could, in some examples, provide the controller 218 of Figure 2.

As will be familiar to the skilled person, a first arm 402a of a pair is used to construct the positive half-cycle of an ac sinewave and the other arm 402b a pair is used to construct the negative half-cycle.

As the voltage that can be supported by semiconductor switches, i.e. their voltage rating, is limited and, as the rating increases, so does cost, the function of a director switch 408 is not usually performed by a single switching element.

An example of a switch 408 suitable for use within an AAC 400 (or another multi-level converter) is shown in Figure 5. The switch 408 comprises a series combination of semiconductor switching elements 502, in this case Insulated Gate Bipolar Transistors (IGBTs). In a typical example, there may be tens of, or even a hundred or more, switching elements 502 in a switch 408.

It is usual to ensure that the individual voltage supported by any single switching element does not exceed its maximum recommended working voltage, which may be defined in terms of its Collector-Emitter Voltage, usually designated V_{CES}. Therefore, the series connected switching elements 502 are operated substantially simultaneous to act together as if one high voltage switch.

Using the control circuitry 200 removes the need for a fibre optic receiver link or the like for the gate controllers, simplifying the design of the converter 400, gate controller(s) and/or control circuitry 200. If all elements 502 are to be controlled to switch simultaneously for safe operation, a single command protocol to either turn on or turn off semiconductor elements 502 can be implemented within the AC current that is looping through all gate boards 202 (which may be associated with all, any or a subset of the switching elements 502 of the director switch 408).

While the invention has been illustrated and described in detail in the drawings and foregoing description, such illustration and description are to be considered illustrative or exemplary and not restrictive; the invention is not limited to the disclosed embodiments. Features from one embodiment may be combined with features from another embodiment.

Although an example has been provided in the context of a director switch of an AAC, in other examples, such a control circuitry 200 may be found in other apparatus. For example, other multilevel converter topologies, such as that described in WO2010/088969, may comprise switches to connect a phase of an AC network to a converter (termed a phase element 40 in the above mentioned application), and such switches could comprise control circuitry 200 as described herein. Control circuitry 200 as described herein may also be used in a modular multilevel converter (often termed an MMC, or and M2LC), such as is described in WO2014/154265 in the name of ABB. The content of these documents is incorporated herein by reference to the fullest possible extent.

The control circuitry 200 could also be used, for example in Flexible AC Transmission and Systems (FACTS) or Static Synchronous Compensator (STATCOMS), or the like, as such apparatus is also likely to include switching elements which it is desired to control simultaneously and/or individually.

The invention has been described with respect to various embodiments. Unless expressly stated otherwise the various features described may be combined together and features from one embodiment may be employed in other embodiments.

It should be noted that the above-mentioned embodiments illustrate rather than limit the invention, and that those skilled in the art will be able to design many alternative embodiments without departing from the scope of the appended claims.

The word "comprising" does not exclude the presence of elements or steps other than those listed in a claim, "a" or "an" does not exclude a plurality, and a single feature or other unit may fulfil the functions of several units recited in the claims. Any reference numerals or labels in the claims shall not be construed so as to limit their scope.

## Claims

**1.** A method of providing power for a gate signal for a semiconductor switching element comprising:
providing an alternating current on a primary conductor;
inducing a current in a secondary conductor using the alternating current on the primary conductor; and
deriving power to provide the gate signal from the current induced on the
secondary conductor;
the method further comprising:
applying a frequency modulation to the alternating current on the primary conductor; and
detecting the frequency modulation in the induced current in the secondary conductor.

**2.** A method according to claim 1 in which the applied frequency modulation is indicative of a data signal, the method further comprising deriving the data signal from the detected frequency modulation.

**3.** A method according to claim 1 or claim 2 further comprising controlling the gate signal according to the detected frequency modulation.

**4.** A method according to any preceding claim further comprising detecting a predetermined identifier in the detected frequency modulation.

**5.** A method according to any preceding claim in which the applied frequency modulation comprises frequency shift keying.

**6.** A method according to any preceding claim in which the step of detecting the frequency modulation comprises monitoring the induced current for at least two cycles.

**7.** A method according to any preceding claim in which the step of detecting the frequency modulation comprises at least one of: monitoring zero crossings in the induced current waveform; monitoring the time between voltage peaks in the induced current; high pass filtering of the induced current.

**8.** Control circuitry arranged to control the switching state of a semiconductor switching element, the control circuitry comprising:
a current source arranged to supply an alternating current;
a modulator arranged to modulate the frequency of the alternating current;
a primary conductor arranged to carry the alternating current; and
at least one gate controller comprising:
a power unit arranged to derive power from the primary conductor via electromagnetic induction;
a demodulator arranged to identify a frequency modulation in the alternating current and to determine a data signal therefrom; and
gate drive circuitry arranged to drive a gate of a semiconductor switching element using power derived by the power unit.

**9.** Control circuitry according to claim 8 in which the gate controller is arranged to derive, from the data signal, at least one of: a semiconductor switching element control signal; an information request signal; a gate drive control signal.

**10.** Control circuitry according to claim 8 or claim 9 in which the primary conductor is a current loop and the or each power unit comprises a ring core transformer winding.

**11.** Control circuitry according to any of claims 8 to 10 in which the modulator is arranged control the frequency of the alternating current using frequency shift keying.

**12.** Control circuitry according to any of claims 8 to 11 in which the modulator is arranged to control the frequency of the alternating current within a range determined by at least one of: a frequency range of the power unit, a desired switching speed of the semi conductor element, demodulator performance limits; anticipated frequency drift of the current source, noise in the control circuitry.

**13.** Control circuitry according to any of claims 8 to 12 comprising a plurality of gate controllers, in which the modulator is arranged to modulate the alternating current to represent a data signal indicative of an identifier of one or more of the gate controllers, and the demodulator of each gate controller is arranged to determine, from the data signal, if the data signal comprises an identifier corresponding to that gate controller.

**13.** A gate controller comprising:
a power unit arranged to derive power via electromagnetic induction from an alternating current;
a demodulator arranged to identify a frequency shift in the alternating current and to determine a data signal therefrom; and
gate drive circuitry arranged to drive a gate of a semiconductor switching element using power derived by the power unit.

**14.** A gate controller according to claim 13 arranged to derive a control signal from the data signal, and wherein the gate drive circuitry is arranged to drive a gate of a semiconductor switching element according to the control signal.

**15.** A gate controller according to claim 13 or 14 in which the power unit comprises a ring core transformer winding and/or a power conditioning module arranged to rectify the induced current.
